# EUROPEAN PATENT APPLICATION

(11) **EP 4 582 601 A1**
(43) Date of publication of application: **09.07.2025**
(21) Application number: 23860120.7
(22) Date of filing: 22.08.2023
(51) Int. Cl.: C30B 29/04, C23C 14/14, C23C 16/27, C30B 25/18, H01L 21/20, H01L 21/205

(54) **BASE SUBSTRATE, SINGLE CRYSTAL DIAMOND MULTILAYER SUBSTRATE, AND PRODUCTION METHOD THEREFOR**

(30) Priority: 02.09.2022 JP 2022140082
(71) Applicant: SHIN-ETSU CHEMICAL CO., LTD., Tokyo 1000005 (JP)
(72) Inventor: NOGUCHI, Hitoshi, Annaka-shi, Gunma 379-0195 (JP)
(74) Representative: Schicker, Silvia
(86) International application number: PCT/JP2023/030066
(87) International publication number: WO 2024/048357

(57) **Abstract**

The present invention is an underlying substrate for a single crystal diamond laminate substrate, the underlying substrate including an initial substrate being any of a single crystal Si {111} substrate, a single crystal α-Al₂O₃ {0001} substrate, etc., and an intermediate layer on the initial substrate, in which an outermost surface on the initial substrate has an off angle in a crystal axis <-1-12> direction relative to a cubic crystal plane orientation {111}, or has an off angle in a crystal axis <10-10> or <11-20> direction relative to a hexagonal crystal plane orientation {0001}, etc. This provides the underlying substrate capable of forming a single crystal diamond layer having a large area (large diameter), high crystallinity, few hillocks, few abnormal growth particles such as twin crystals, few dislocation defects, etc., high purity, low stress, and high quality and applicable to an electronic and magnetic device.

## Description

### TECHNICAL FIELD

The present invention relates to an underlying substrate, a single crystal diamond laminate substrate, and a method for producing them.

### BACKGROUND ART

Diamond has a wide band gap of 5.47 eV at room temperature and is known as a wide bandgap semiconductor.

Among semiconductors, diamond has an extremely high dielectric breakdown electric field strength of 10 MV/cm, and a high-voltage operation can be performed.
In addition, diamond has the highest thermal conductivity among known materials, and has an excellent heat radiation property thereby. Further, diamond has very large carrier mobility and saturated drift velocity and is suitable for a high speed device.

Accordingly, diamond has the highest Johnson performance index, which indicates a property as a radio-frequency and high power device, compared to semiconductors such as silicon carbide and gallium nitride, and is said to be an ultimate semiconductor thereby.

### CITATION LIST

### NON PATENT LITERATURE

Non Patent Document 1: H.Yamada, Appl. Phys. Lett.104, 102110 (2014).

### SUMMARY OF INVENTION

### TECHNICAL PROBLEM

As described above, diamond is expected to be used practically as a material for semiconductors or a material for electronic and magnetic devices, and supply of a diamond substrate with a large area and high quality is desired.

Currently, most of single crystal diamond for producing a diamond semiconductor is diamond referred to as Ib-type diamond which is synthesized using a highpressure-high-temperature method (HPHT). This Ib-type diamond contains a number of nitrogen impurities and can be obtained in a size of only approximately 8 mm square at maximum, and therefore has less practicability. Moreover, another method, referred to as a mosaic method, in which a large number of HPHT substrates (the diamond substrates synthesized by the HPHT method) are arranged in a row and joined together, has been proposed (Non-Patent Document 1), but the problem of imperfections in the joints remains.

In contrast, a vapor synthesis (Chemical Vapor Deposition: CVD) method can provide large-area diamonds having a diameter of approximately 6 inches (150 mm) with high purity when polycrystal diamonds are acceptable; however, single crystallization, which is generally suited for electronic devices, is difficult. This is because a combination of suitable materials, as an underlying substrate for forming the diamond with small differences in lattice constants and linear expansion coefficients with the diamond, has not been realized, for example, a difference in the lattice constant between the diamond and single crystal Si has even 34.3 %; therefore, it is very difficult to grow the diamond heteroepitaxially on a surface of the underlying substrate.

The present invention has been made to solve the above-described problem. An object of the present invention is to provide an underlying substrate capable of forming a single crystal diamond layer having a large area (large diameter), high crystallinity, few hillocks, few abnormal growth particles, few dislocation defects, etc., high purity, low stress, and high quality and applicable to an electronic and magnetic device, and a method for producing such a substrate. Moreover, another object is to provide a method for producing a single crystal diamond laminate substrate having such a single crystal diamond layer and a method for producing a single crystal diamond freestanding structure substrate.

### SOLUTION TO PROBLEM

In order to solve the above problem, the present invention provides an underlying substrate for a single crystal diamond laminate substrate, the underlying substrate comprising:
an initial substrate being any of a single crystal Si {111} substrate, a single crystal Si {001} substrate, a single crystal α-Al₂O₃ {0001} substrate, a single crystal α-Al₂O₃ {11-20} substrate, a single crystal Fe {111} substrate, a single crystal Fe {001} substrate, a single crystal Ni {111} substrate, a single crystal Ni {001} substrate, a single crystal Cu {111} substrate, and a single crystal Cu {001} substrate; and
an intermediate layer comprising a single layer or a laminate film on the initial substrate containing at least any one of a single crystal Ir film, a single crystal MgO film, a single crystal yttria-stabilized zirconia film, a single crystal SrTiO₃ film, and a single crystal Ru film, wherein
an outermost surface on the initial substrate has an off angle in a crystal axis <-1-12> direction relative to a cubic crystal plane orientation {111}, or has an off angle in a crystal axis <10-10> or <11-20> direction relative to a hexagonal crystal plane orientation {0001}, or has an off angle in a crystal axis <110> direction relative to a cubic crystal plane orientation {001}, or has an off angle in a crystal axis <10-10> or <0001> direction relative to a hexagonal crystal plane orientation {11-20}.

With such an underlying substrate; the initial substrate, the off angle thereof, and the intermediate layer are appropriately combined to enable the underlying substrate to form a single crystal diamond layer having a large diameter, high crystallinity, few hillocks, few abnormal growth particles, few dislocation defects, etc., high purity, low stress, and high quality and suitable for an electronic and magnetic device.

In this case, the off angle of the outermost surface on the initial substrate can be in a range of +8.0° to +24.0° or -8.0° to -24.0°. In addition, the off angle of the outermost surface on the initial substrate can be in a range of greater than +15.0° to +24.0° or less, or greater than -15.0° to -24.0° or less.

By making the range such as this, qualitative improvement effect due to the off angle can be maximized.

Moreover, an outermost surface on the intermediate layer can have an off angle in a crystal axis <-1-12> direction relative to a cubic crystal plane orientation {111}, or have an off angle in a crystal axis <10-10> or <11-20> direction relative to a hexagonal crystal plane orientation {0001}, or have an off angle in a crystal axis <110> direction relative to a cubic crystal plane orientation {001}, or have an off angle in a crystal axis <10-10> or <0001> direction relative to a hexagonal crystal plane orientation {11-20}.

By providing the off angle in this way, the underlying substrate can be made in which the single-crystal diamond layer having high crystallinity, few hillocks, few abnormal growths such as twin crystals, few dislocation defects, and high quality can be obtained more effectively.

In this case, the off angle of the outermost surface on the intermediate layer can be in a range of +8.0° to +24.0° or -8.0° to -24.0°. In addition, the off angle of the outermost surface on the intermediate layer can be in a range of greater than +15.0° to +24.0° or less, or greater than -15.0° to -24.0° or less.

By making the range such as this, qualitative improvement effect due to the off angle can be maximized.

Moreover, the present invention provides a single crystal diamond laminate substrate comprising a single crystal diamond layer on the intermediate layer of any of the underlying substrates described above.

Such a single crystal diamond laminate substrate can be the single crystal diamond laminate substrate having a single crystal diamond layer with a large diameter, high crystallinity, few hillocks, few abnormal growth particles, few dislocation defects, etc., high purity, low stress, and high quality and suitable for the electronic and magnetic device.

In this case, in the inventive single crystal diamond laminate substrate, the single crystal diamond layer is preferably a {111} crystal or a {001} crystal.

The inventive single crystal diamond laminate substrate can have the single crystal diamond layer having these plane orientations on the underlying substrate.

Moreover, the present invention provides a method for producing an underlying substrate for a single crystal diamond laminate substrate, the method comprising the steps of:
providing an initial substrate being any of a single crystal Si {111} substrate, a single crystal Si {001} substrate, a single crystal α-Al₂O₃ {0001} substrate, a single crystal α-Al₂O₃ {11-20} substrate, a single crystal Fe {111} substrate, a single crystal Fe {001} substrate, a single crystal Ni {111} substrate, a single crystal Ni {001} substrate, a single crystal Cu {111} substrate, and a single crystal Cu {001} substrate; and
forming an intermediate layer comprising a single layer or a laminate film on the initial substrate containing at least any one of a single crystal Ir film, a single crystal MgO film, a single crystal yttria-stabilized zirconia film, a single crystal SrTiO₃ film, and a single crystal Ru film, wherein
the initial substrate is used with any of the outermost surfaces on the initial substrates which have an off angle in a crystal axis <-1-12> direction relative to a cubic crystal plane orientation {111}, or have an off angle in a crystal axis <10-10> or <11-20> direction relative to a hexagonal crystal plane orientation {0001}, or have an off angle in a crystal axis <110> direction relative to a cubic crystal plane orientation {001}, or have an off angle in a crystal axis <10-10> or <0001> direction relative to a hexagonal crystal plane orientation {11-20}.

According to the method for producing such an underlying substrate, by appropriately combining of the initial substrate, the off angle thereof, and the intermediate layer; the underlying substrate can be produced, in which the substrate is capable of forming a single crystal diamond layer having a large diameter, high crystallinity, few hillocks, few abnormal growth particles, few dislocation defects, etc., high purity, low stress, and high quality and suitable for an electronic and magnetic device.

In this case, the off angle of the outermost surface on the initial substrate can be in a range of +8.0° to +24.0° or -8.0° to -24.0°. Moreover, the off angle of the outermost surface on the initial substrate can be in a range of greater than +15.0° to +24.0° or less, or greater than -15.0° to -24.0° or less.

By using the initial substrate having the off angle in such a range, qualitative improvement effect due to the off angle can be maximized.

Moreover, an outermost surface on the intermediate layer can have an off angle in a crystal axis <-1-12> direction relative to a cubic crystal plane orientation {111}, or have an off angle in a crystal axis <10-10> or <11-20> direction relative to a hexagonal crystal plane orientation {0001}, or have an off angle in a crystal axis <110> direction relative to a cubic crystal plane orientation {001}, or have an off angle in a crystal axis <10-10> or <0001> direction relative to a hexagonal crystal plane orientation {11-20}.

By providing the off angle in this way, the underlying substrate can be produced, in which the single-crystal diamond layer having high crystallinity, few hillocks, few abnormal growths, few dislocation defects, and high quality can be obtained more effectively.

In this case, the intermediate layer can be formed with the off angle of the outermost surface on the intermediate layer in a range of +8.0° to +24.0° or - 8.0° to -24.0°. Furthermore, the intermediate layer can be formed with the off angle of the outermost surface on the intermediate layer in a range of greater than +15.0° to +24.0° or less, or greater than -15.0° to -24.0° or less.

By making the range such as this, qualitative improvement effect due to the off angle can be maximized.

Moreover, the present invention provides a method for producing a single crystal diamond laminate substrate, the method comprising the steps of:
providing an underlying substrate produced by any of the above methods for producing an underlying substrate;
performing a bias treatment on a surface of the intermediate layer of the underlying substrate to form a diamond nucleus; and
growing the diamond nucleus formed on the intermediate layer to perform epitaxial growth, thereby forming a single crystal diamond layer.

The single crystal diamond laminate substrate produced in this way can be the single crystal diamond laminate substrate having the single crystal diamond layer with a large diameter, high crystallinity, few hillocks, few abnormal growth particles, few dislocation defects, etc., high purity, low stress, and high quality and suitable for the electronic and magnetic device.

In this case, in the inventive single crystal diamond laminate substrate, the single crystal diamond layer is preferably a {111} crystal or a {001} crystal.

In the inventive single crystal diamond laminate substrate, the single crystal diamond laminate substrate can be produced, which has the single crystal diamond layer having these plane orientations on the underlying substrate described above.

Moreover, the present invention provides a method for producing a single crystal diamond freestanding structure substrate, the method comprising taking out only the single crystal diamond layer from a single crystal diamond laminate substrate produced by any of the above methods for producing a single crystal diamond laminate substrate to produce a single crystal diamond freestanding structure substrate.

In this way, the single crystal diamond freestanding structure substrate composed of only the single crystal diamond layer can be produced.

Moreover, an additional single crystal diamond layer can also be further formed on the single crystal diamond freestanding structure substrate obtained by the above method for producing a single crystal diamond freestanding structure substrate.

In this way, it is also possible to further thicken a film by performing additional forming on the substrate having only the diamond layer.

### ADVANTAGEOUS EFFECTS OF INVENTION

According to the inventive underlying substrate and the method for producing this substrate; the initial substrate, the off angle thereof, and the intermediate layer are appropriately combined to form the diamond layer, and this allows the laminate substrate to have the single crystal diamond layer having a large diameter, high crystallinity, few hillocks, few abnormal growth particles, few dislocation defects, etc., high purity, low stress, and high quality and suitable for an electronic and magnetic device. Moreover, according to the present invention, it is also possible to produce a single crystal diamond freestanding structure substrate by taking out only the single crystal diamond layer from such a single crystal diamond laminate substrate or to also produce a single crystal freestanding diamond substrate in which an additional single crystal diamond layer is further formed on the single crystal freestanding diamond substrate.

### BRIEF DESCRIPTION OF DRAWINGS

FIG. 1 is a schematic view illustrating an example of an underlying substrate according to the present invention.
FIG. 2 is a schematic view illustrating an example of a single crystal diamond laminate substrate according to the present invention.
FIG. 3 is a schematic view illustrating an example of a single crystal diamond freestanding structure substrate according to the present invention.
FIG. 4 is a schematic view illustrating another example of a single crystal diamond freestanding structure substrate according to the present invention.
FIG. 5 is a flowchart illustrating an example of a method for producing an underlying substrate according to the present invention.
FIG. 6 is a flowchart illustrating an example of a process of a method for producing a single crystal diamond laminate substrate and a process of a method for producing a single crystal freestanding structure substrate according to the present invention.
FIG. 7 is a result of a pole method by an X-ray diffraction measurement in Example 1.
FIG. 8 is a result of an Out-of-plane method by an X-ray diffraction measurement in Example 1.
FIG. 9 is a result of a pole method by an X-ray diffraction measurement in Comparative Example.
FIG. 10 is a result of an Out-of-plane method by an X-ray diffraction measurement in Comparative Example.

### DESCRIPTION OF EMBODIMENTS

Hereinafter, the present invention will be described in detail. However, the present invention is not limited thereto.

As described above, conventionally, it has been desired to obtain a single crystal diamond laminate substrate having a large diameter and high quality at a low cost. Accordingly, the present inventor has earnestly studied to solve such a problem. As a result, the inventor has found a selection of an optimum material for an initial substrate and an optimum material for an intermediate layer and a formation method thereof in a single crystal diamond laminate substrate and an underlying substrate for producing the single crystal diamond laminate substrate. This finding has led to the completion of the present invention.

Hereinafter, the present invention will be more specifically described, referring to the drawings. Similar components below are described with the same reference signs.

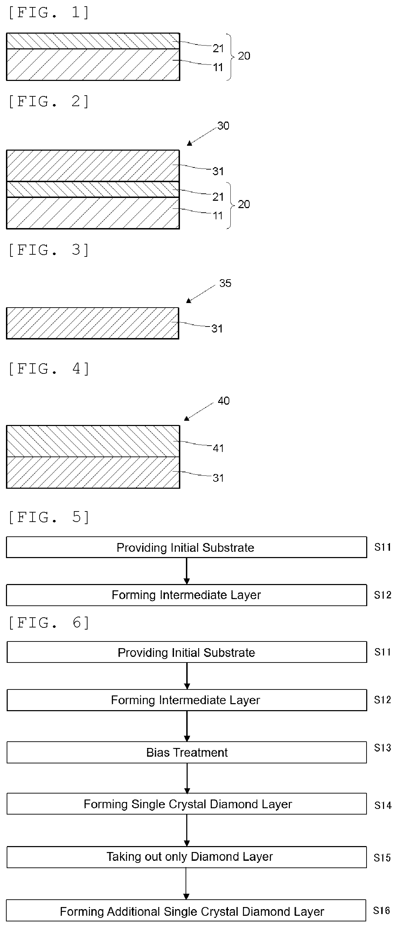

First, the inventive underlying substrate and single crystal diamond laminate substrate are described referring to FIGs. 1 and 2.

As shown in FIG. 1, the inventive underlying substrate 20 for the single crystal diamond laminate substrate includes an initial substrate 11 and an intermediate layer 21 on the initial substrate 11. In the present invention, the initial substrate 11 is any of a single crystal Si {111} substrate, a single crystal Si {001} substrate, a single crystal α-Al₂O₃ {0001} substrate, a single crystal α-Al₂O₃ {11-20} substrate, a single crystal Fe {111} substrate, a single crystal Fe {001} substrate, a single crystal Ni {111} substrate, a single crystal Ni {001} substrate, a single crystal Cu {111} substrate, and a single crystal Cu {001} substrate. In addition, the intermediate layer 21 on the initial substrate 11 includes a layer composed of a single layer or a laminate film containing at least any one of a single crystal Ir film, a single crystal MgO film, a single crystal yttria-stabilized zirconia film, a single crystal SrTiO₃ film, and a single crystal Ru film. In the inventive underlying substrate 20, in addition, an outermost surface on the initial substrate 11 has an off angle in a crystal axis <-1-12> direction relative to a cubic crystal plane orientation {111}, or has an off angle in a crystal axis <10-10> or <11-20> direction relative to a hexagonal crystal plane orientation {0001}, or has an off angle in a crystal axis <110> direction relative to a cubic crystal plane orientation {001}, or has an off angle in a crystal axis <10-10> or <0001> direction relative to a hexagonal crystal plane orientation {11-20}.

Moreover, as shown in FIG. 2, the inventive single crystal diamond laminate substrate 30 includes a single crystal diamond layer 31 on the intermediate layer 21 of the underlying substrate 20 shown in FIG. 1. The intermediate layer 21 has a role in mitigating a lattice mismatch between the initial substrate 11 and the single crystal diamond layer 31.

As described above, the initial substrate 11 is any of the single crystal Si {111} substrate, the single crystal Si {001} substrate, the single crystal α-Al₂O₃ {0001} substrate, the single crystal α-Al₂O₃ {11-20} substrate, the single crystal Fe {111} substrate, the single crystal Fe {001} substrate, the single crystal Ni {111} substrate, the single crystal Ni {001} substrate, the single crystal Cu {111} substrate, and the single crystal Cu {001} substrate. Since a lattice mismatch between these initial substrates 11 (bulk substrates) and materials of the intermediate layer 21 is small, epitaxial growth of the intermediate layer 21 is easily enabled when the intermediate layer 21 is formed. Moreover, a substrate having a large diameter exceeding 6 inches (150 mm) can also be obtained, and the price thereof can be relatively low.

In this event, when a {111} crystal and a {001} crystal are desired to obtain as the single crystal diamond layer 31 to be formed, the initial substrate 11 is selected accordingly.

Furthermore, the off angle of the outermost surface of the initial substrate 11 is prescribed as specified above. That is, the outermost surface of the initial substrate 11 may have the off angle in the crystal axis <-1-12> direction relative to the cubic crystal plane orientation {111} of the single crystal Si {111} substrate, etc., or may have the off angle in the crystal axis <10-10> or <11-20> direction relative to the hexagonal crystal plane orientation {0001} of the single crystal α-Al₂O₃ {0001} substrate, etc. Moreover, the outermost surface of the initial substrate 11 may have the off angle in the crystal axis <110> direction relative to a cubic crystal plane orientation {001} of the single crystal Si {001} substrate, etc., or may have the off angle in the crystal axis <10-10> or <0001> direction relative to the hexagonal crystal plane orientation {11-20} of the single crystal α-Al₂O₃ {11-20} substrate, etc.

By having such a specification for the off angle, the high quality intermediate layer having high crystallinity, few hillocks, few abnormal growths, few dislocation defects, etc., can be obtained as the intermediate layer formed on the outermost surface of the initial substrate 11.

When providing the off angle on the outermost surface of the initial substrate 11, the off angle is preferably in a range of +8.0° to +24.0° or -8.0° to - 24.0°. When this off angle is +8.0° or more, or -8.0° or more, an effect of providing the off angle can be sufficiently obtained. When the off angle is +24.0° or less and -24.0° or less, an effect of improving quality can be sufficiently obtained.

Furthermore, when providing the off angle on the outermost surface of the initial substrate 11, the off angle is more preferably in a range of greater than +15.0° to +24.0° or less, or greater than -15.0° to - 24.0° or less. With such a range of the off angle, an effect from providing the off angle can be obtained sufficiently and more stably, and a qualitative improvement effect can be obtained sufficiently and more stably.

It is preferred that a surface of the initial substrate 11 where the intermediate layer is formed is polish processed to make Ra≤0.5 nm. Accordingly, a smooth intermediate layer having few defects can be formed.

As described above, the intermediate layer 21 is composed of the single layer or the laminate film containing at least any one of the single crystal Ir film, the single crystal MgO film, the single crystal yttria-stabilized zirconia film, the single crystal SrTiO₃ film, and the single crystal Ru film.

As described above, in the inventive underlying substrate 20, the intermediate layer 21, which has excellent quality, can be realized not only by the single layer made of the above material but also by the laminated structure. Such a laminate film can be designed to have the role of mitigating a lattice mismatch between the initial substrate 11 and the single crystal diamond layer 31 more appropriately. For example, by forming the laminated structure in which order from the surface side can be the surface side to the Ir film/MgO film and to the initial substrate 11 side; similarly, by forming the laminated structure including the Ir film/YSZ film or the Ir film/SrTiO₃ film, etc., the role to mitigate the lattice mismatch can be given more effectively.

It is preferred that the intermediate layer 21 has a thickness of 5 nm or more and 50 µm or less. When the intermediate layer 21 has a thickness of 5 nm or more, such a layer is not removed in a subsequent diamond-forming step. Moreover, when the intermediate layer 21 has a thickness of 50 µm or less, the thickness thereof is sufficient as the thickness of the intermediate layer 21. In addition, when the thickness is 50 µm or less, the time for film-forming is not too long, and surface roughness can be maintained low. Consequently, polish processing is not necessarily required. Thus, the film-forming at a low cost is possible.

It is possible to make the outermost surface of the intermediate layer 21 have the off angle. The outermost surface on the intermediate layer 21 can have the off angle in the crystal axis <-1-12> direction relative to the cubic crystal plane orientation {111} or have the off angle in the crystal axis <10-10> or <11-20> direction relative to the hexagonal crystal plane orientation {0001}. Moreover, the outermost surface on the intermediate layer 21 can have the off angle in the crystal axis <110> direction relative to the cubic crystal plane orientation {001}, or have an off angle in the crystal axis <10-10> or <0001> direction relative to a hexagonal crystal plane orientation {11-20}. By determining such a specification for the off angle on the outermost surface of the intermediate layer 21, the high quality single crystal diamond layer having high crystallinity, few hillocks, few abnormal growths, few dislocation defects, etc., can be obtained as the diamond formed on the surface.

In this event, it is preferred that the off angle of the outermost surface on the intermediate layer 21 is in a range of +8.0° to +24.0° or -8.0° to -24.0°. When this off angle is +8.0 or more or -8.0° or more, an effect from providing the off angle can be obtained sufficiently, and when the off angle is +24.0 or less or -24.0 or less, a qualitative improvement effect can be obtained sufficiently. In addition, when within these ranges, a deviation from a crystal plane of the outermost surface is not too large; thus, it is easy to use according to an intended purpose.

Furthermore, the off angle on the outermost surface of the intermediate layer 21 is more preferably in a range of greater than +15.0° to +24.0° or less, or greater than -15.0° to -24.0° or less. With such a range of the off angle, an effect from providing the off angle can be obtained sufficiently and more stably, and a qualitative improvement effect can be obtained sufficiently and more stably.

Hereinafter, methods for producing the underlying substrate and the single crystal diamond laminate substrate shown in FIGs. 1 and 2 are described. The inventive method for producing the underlying substrate is described referring to FIG. 5, and the inventive method for producing the single crystal diamond laminate substrate is described referring to FIG. 6.

In addition, in the present invention, it is possible to produce a single crystal diamond freestanding structure substrate 35 composed of the single crystal diamond layer 31 shown in FIG. 3, and a single crystal diamond freestanding structure substrate 40 composed of the single crystal diamond layer 31 and an additional single crystal diamond layer 41 shown in FIG. 4, and this producing method is also described referring to FIG. 6.

### (Providing Step: Step S11 in FIG. 5)

First, initial substrate 11 is provided (Step S11). The initial substrate 11 is any of the substrates (bulk substrates) including a single crystal Si {111} substrate, a single crystal Si {001} substrate, a single crystal α-Al₂O₃ {0001} substrate, a single crystal α-Al₂O₃ {11-20} substrate, a single crystal Fe {111} substrate, a single crystal Fe {001} substrate, a single crystal Ni {111} substrate, a single crystal Ni {001} substrate, a single crystal Cu {111} substrate, and a single crystal Cu {001} substrate. These listed materials of the initial substrate 11 have a small lattice mismatch with materials of the intermediate layer 21; thus, epitaxial growth of the intermediate layer 21 can be performed easily. Moreover, the substrate having a large diameter exceeding 6 inches (150 mm) can be obtained, and a price thereof is relatively low.

Moreover, as the initial substrate 11, any of the initial substrates is used in which an outermost surface on the initial substrate has an off angle in a crystal axis <-1-12> direction relative to a cubic crystal plane orientation {111}, or has an off angle in a crystal axis <10-10> or <11-20> direction relative to a hexagonal crystal plane orientation {0001}, or has an off angle in a crystal axis <110> direction relative to a cubic crystal plane orientation {001}, or has an off angle in a crystal axis <10-10> or <0001> direction relative to a hexagonal crystal plane orientation {11-20}. By using such an initial substrate 11, the high quality intermediate layer 21 having high crystallinity, few hillocks, few abnormal growths, few dislocation defects, etc., can be obtained more effectively as the intermediate layer 21 formed on the surface.

When it is desired to obtain a crystal plane orientation {111} for the single crystal diamond layer 31, the outermost surface of the initial substrate 11 can be made to have the off angle in the crystal axis <-1-12> direction relative to the cubic crystal plane orientation {111} or have the off angle in the crystal axis <10-10> or <11-20> direction relative to the hexagonal crystal plane orientation {0001}. On the other hand, when is desired to obtain a crystal plane orientation {001} for the single crystal diamond layer, the outermost surface of the initial substrate 11 can be made to have an off angle in a crystal axis <110> direction relative to a cubic crystal plane orientation {001}, or has an off angle in a crystal axis <10-10> or <0001> direction relative to a hexagonal crystal plane orientation {11-20}.

It is preferred that a surface of the initial substrate 11 where the intermediate layer 21 is formed is polish processed to make Ra≤0.5 nm. Accordingly, a smooth intermediate layer 21, having few defects, can be formed.

It is preferred that the off angle on the outermost surface of the initial substrate 11 at this time is in a range of +8.0° to +24.0° or -8.0° to -24.0°. When this off angle is +8.0° or more or -8.0° or more, an effect of providing the off angle can be obtained sufficiently, and when the off angle is +24.0 or less or -24.0 or less, a qualitative improvement effect can be sufficiently obtained. In addition, when the off angles are within these ranges, a deviation from a crystal plane of the outermost surface is not too large; thus, it is easy to use according to an intended purpose.

Furthermore, the off angle on the outermost surface of the initial substrate 11 is more preferably in a range of greater than +15.0° to +24.0° or less, or greater than -15.0° to -24.0° or less. With such a range of the off angle, an effect from providing the off angle can be obtained sufficiently and more stably, and a qualitative improvement effect can be obtained sufficiently and more stably.

### (Forming Intermediate Layer Step: Step S12 in FIG. 5)

After providing the initial substrate 11 in the step S11, next, the intermediate layer 21 is formed on the initial substrate 11. The intermediate layer 21 is composed of the single layer or the laminate film containing at least any one of the single crystal Ir film, the single crystal MgO film, the single crystal yttria-stabilized zirconia film, the single crystal SrTiO₃ film, and the single crystal Ru film (Step S12).

At this point, it is possible to make the outermost surface of the intermediate layer 21 have the off angle. The outermost surface on the intermediate layer 21 can have the off angle in the crystal axis <-1-12> direction relative to the cubic crystal plane orientation {111}, or have the off angle in the crystal axis <10-10> or <11-20> direction relative to the hexagonal crystal plane orientation {0001}. Moreover, the outermost surface on the intermediate layer 21 can have the off angle in the crystal axis <110> direction relative to the cubic crystal plane orientation {001}, or have an off angle in the crystal axis <10-10> or <0001> direction relative to the hexagonal crystal plane orientation {11-20}. By determining such a specification for the off angle on the outermost surface of the intermediate layer 21, the high quality single crystal diamond layer having high crystallinity, few hillocks, few abnormal growths, few dislocation defects, etc., can be obtained as the diamond formed on the surface.

When it is desired to obtain a crystal plane orientation {111} as the single crystal diamond layer 31, at least the outermost surface of the intermediate layer 21 may also be made to the crystal plane orientation {111} in a case of the cubic crystal, and the crystal plane orientation {0001} in a case of the hexagonal crystal. On the other hand, when it is desired to obtain a crystal plane orientation {001} as the single crystal diamond layer 31, at least the outermost surface of the intermediate layer 21 may also be made to the crystal plane orientation {001} in a case of the cubic crystal, and the crystal plane orientation {11-20} in a case of the hexagonal crystal.

In this event, it is preferred that the off angle of the outermost surface on the intermediate layer 21 is in a range of +8.0° to +24.0° or -8.0° to -24.0°. When this off angle is +8.0° or more or -8.0° or more, an effect from providing the off angle can be obtained sufficiently, and when the off angle is +24.0 or less or -24.0 or less, a qualitative improvement effect can be sufficiently obtained. In addition, when the off angle is within these ranges, a deviation from a crystal plane of the outermost surface is not too large; thus, it is easy to use according to an intended purpose.

Furthermore, it is preferred that the off angle of the outermost surface on the intermediate layer 21 is in a range of greater than +15.0° to +24.0° or less, or greater than -15.0° to -24.0° or less. With such a range of the off angle, an effect from providing the off angle can be obtained sufficiently and more stably, and a qualitative improvement effect can be obtained sufficiently and more stably.

The formation of intermediate layer 21 can be performed by a sputtering method, an electron beam vapor-deposition method, an atomic layer deposition method, a molecular beam epitaxy method, a pulsed laser deposition method, etc. Moreover, the single crystal Ir film, the single crystal MgO film, the single crystal yttria-stabilized zirconia (YSZ) film, the single crystal SrTiO₃ film, and the single crystal Ru film, which are the metals and metal oxides used in the present invention can be formed by a mist CVD which enables large-diameter and low-cost formation.

A film-forming apparatus by the mist CVD method is configured with a mist-atomizing unit to atomize a raw material solution, in which atoms of materials to-be-formed are contained, into the mist by an ultrasonic vibration to generate the mist; a carrier gas supply unit to supply a carrier gas for transporting the mist; a chamber in which a substrate is set to form the film; and an exhaust system to discharges unnecessary raw material.

The substrate is heated on a heater stage in the chamber and rotated and the like as necessary so as to enable highly crystallized and uniform film formation. A raw material gas flow is also controlled to enable highly crystallized and uniform film formation.

Additionally, the substrate can be placed on the heater stage installed in an open system, and then the film forming can be performed by thermal reaction by supplying the mist from a mist discharge nozzle onto a surface of the substrate.

The material contained in the raw material solution is not particularly limited and may be inorganic or organic material as long as the raw material solution contains at least metal atoms to be formed and can be atomized into the mist.

The raw material solution is not particularly limited as long as the metal atom described above can be atomized into the mist, but the metal dissolved or dispersed into an organic solvent or water in a form of a complex or a salt can be suitably used as the raw material solution. As the forms of complexes, for example, acetylacetonate complex, carbonyl complex, ammine complex, and hydride complex, etc., can be exemplified. As the forms of salts, for example, metal chloride salt, metal bromide salt, metal iodide salt, etc., are exemplified. In addition, the above metal dissolved in hydrobromic acid, hydrochloric acid, hydrogen iodide, etc., can be used as a salt aqueous solution.

Moreover, an additive such as hydrohalic acid and oxidizing agent may also be mixed in the raw material solution. As to hydrohalic acid, for example, hydrobromic acid, hydrochloric acid, hydroiodic acid, etc., are exemplified, among which hydrobromic acid and hydroiodic acid are preferred. As to the oxidizing agents, for example, peroxides such as hydrogen peroxide, sodium peroxide, barium peroxide, benzoyl peroxide, etc., organic peroxides such as hypochlorous acid, perchloric acid, nitric acid, ozonated water, peracetic acid, and nitrobenzene, etc., are also exemplified.

As to the raw material solution for forming MgO, magnesium chloride aqueous solution can also be used.

To obtain an oxide composed of multi-element metal, a plurality of raw material solutions may be mixed to atomize into the mist or each element may be atomized into the mist as separated raw material solutions.

It is preferred to form the film by heating in a substrate temperature range of 200 to 1000°C.

As described above, the intermediate layer 21, which is of excellent quality, can be realized not only by the single layer made of the above material but also by the laminated structure. For example, by forming the laminated structure in which order can be from the surface side to the Ir film/MgO film and then to the initial substrate 11 side; similarly, by forming the laminated structure including the Ir film/YSZ film or the Ir film/SrTiO₃ film, the role to mitigate the lattice mismatch can be given more effectively.

It is preferred that the intermediate layer 21 has a thickness of 5 nm or more and 50 µm or less. When the intermediate layer 21 has a thickness of 5 nm or more, such a layer is not removed in a subsequent diamond-forming step. Moreover, when the intermediate layer 21 has a thickness of 50 µm or less, the thickness thereof is sufficient as the thickness of the intermediate layer 21. In addition, when the thickness is 50 µm or less, the time for film-forming is not too long, and surface roughness can be maintained low. Consequently, polish processing is not necessarily required. Thus, the film-forming at a low cost is possible.

As described above, the outermost surface on the intermediate layer 21 can have the off angle in the crystal axis <-1-12> direction relative to the cubic crystal plane orientation {111} or have the off angle in the crystal axis <10-10> or <11-20> direction relative to the hexagonal crystal plane orientation {0001}. As a result, a high quality single crystal diamond {111} layer having high crystallinity, few hillocks, few abnormal growths, few dislocation defects, etc., can be obtained more effectively as the single crystal diamond layer 31 formed on the surface.

In this event, it is preferred that the off angle of the outermost surface on the intermediate layer 21 is in a range of +8.0° to +24.0° or -8.0° to -24.0°. When this off angle is +8.0° or more or -8.0° or more, an effect from providing the off angle can be obtained sufficiently, and when the off angle is +24.0 or less or -24.0 or less, a qualitative improvement effect can be obtained sufficiently. In addition, when within these ranges, a deviation from a {111} crystal plane of the outermost surface is not too large; thus, it is easy to use according to an intended purpose.

Moreover, it is more preferred that the off angle of the outermost surface on the intermediate layer 21 is in a range of greater than +15.0° to +24.0° or less, or greater than -15.0° to -24.0° or less. With such a range of the off angle, an effect from providing the off angle can be obtained sufficiently and more stably, and a qualitative improvement effect can be obtained sufficiently and more stably.

As described above, the outermost surface on the intermediate layer 21 can have the off angle in the crystal axis <110> direction relative to the cubic crystal plane orientation {001} or have the off angle in the <10-10> or <0001> direction relative to the hexagonal crystal plane orientation {11-20}; thus, a high quality single crystal diamond {001} layer having high crystallinity, few hillocks, few abnormal growths, few dislocation defects, etc., can be obtained as the diamond formed on the surface.

In this event, it is preferred that the off angle of the outermost surface on the intermediate layer 21 is in a range of +8.0° to +24.0° or -8.0° to -24.0°. When this off angle is +8.0° or more or -8.0° or more, an effect from providing the off angle can be obtained sufficiently, and when the off angle is +24.0 or less or -24.0 or less, a qualitative improvement effect can be obtained sufficiently. In addition, when within these ranges, a deviation from a {001} crystal plane of the outermost surface is not too large; thus, it is easy to use according to an intended purpose.

Furthermore, it is more preferred that the off angle of the outermost surface on the intermediate layer 21 is in a range of greater than +15.0° to +24.0° or less, or greater than -15.0° to -24.0° or less. With such a range of the off angle, an effect from providing the off angle can be obtained sufficiently and more stably, and a qualitative improvement effect can be obtained sufficiently and more stably.

By the steps S11 and S12 in FIG. 5 above, the inventive underlying substrate 20 (see FIG. 1) can be produced.

Furthermore, the present invention provides a method for producing a single crystal diamond laminate substrate 30; the method includes the steps of providing the underlying substrate 20 produced by the method for producing the underlying substrate 20 described above, performing a bias treatment on a surface of the intermediate layer 21 of the underlying substrate 20 to form a diamond nucleus, and growing the diamond nucleus formed on the intermediate layer 21 to perform epitaxial growth, thereby forming the single crystal diamond layer 31. Hereinafter, a description is given in more detail.

S11 and S12 in FIG. 6 are the same steps with S11 and S12 in FIG. 5. The underlying substrate 20 is produced by the steps S11 and 12. Moreover, the single crystal diamond laminate substrate 30 is produced by performing the following steps S13 and S14 shown in FIG. 6.

### (Bias Treatment Step: S13 in FIG. 6)

The bias treatment is performed on the surface of the intermediate layer 21 of the underlying substrate 20 to form the diamond nucleus (Step S13). The underlying substrate 20, in which the intermediate layer 21 has been formed, is placed in a decompression chamber, and after the chamber is depressurized by a vacuum pump, the nucleus of the diamond that has a crystal orientation aligned with the outermost surface of the intermediate layer 21 is formed by a direct-current discharge. The discharge gas is preferably hydrogen-diluted methane.

### (Single Crystal Diamond Layer Step: S14 in FIG. 6)

Next, the diamond nucleus formed on the intermediate layer 21 is grown to perform epitaxial growth, thereby forming the single crystal diamond layer 31 (Step S14). That is, a single crystal layer is formed on the bias-treated underlying substrate 20. This step can be performed by, e.g., microwave plasma CVD, DC plasma CVD, thermal filament CVD, or arc discharge CVD, which are chemical vapor deposition (CVD) methods.

The single crystal diamond layer 31 can be composed of each of the single layers of an undoped or doped diamond or an undoped and doped diamond laminated structure.

By the steps S13 and S14, which follow steps S11 and S12 above, the inventive single crystal diamond laminate substrate 30 (see FIG. 2) can be produced.

Moreover, in the method for producing a single crystal diamond laminate substrate described above, the single crystal diamond {111} can be obtained by making the crystal orientation to {111} for cubic crystal, {0001} for hexagonal crystal in either or both of the initial substrate 11 and intermediate layer 21. For example, the single crystal diamond {111} can be formed using any of the single crystal Si {111} substrate, and the single crystal α-Al₂O₃ {0001} substrate as the initial substrate 11.

On the other hand, in the method for producing a single crystal diamond laminate substrate described above, the single crystal diamond {001} can be obtained by making the crystal orientation to {001} for cubic crystal, {11-20} for hexagonal crystal in either or both of the initial substrate 11 and intermediate layer 21. For example, the single crystal diamond {001} can be formed using any of the single crystal Si {001} substrate and the single crystal α-Al₂O₃ {11-20} substrate as the initial substrate 11.

The present invention also provides a method for producing a single crystal diamond freestanding structure substrate, the method includes taking out only the single crystal diamond layer 31 from the single crystal diamond laminate substrate 30 produced through the steps S11 to S14 according to the method above to produce a single crystal diamond freestanding structure substrate 35 (see FIG. 3). Hereinafter, the description is given in more detail.

### (Single Crystal Diamond Taking Out Step: S15 in FIG. 6)

In this step, after the single crystal diamond layer 31 forming step (Step S14), only the single crystal diamond layer 31 is taken out to make the single crystal diamond freestanding structure substrate 35 (Step S15). Such freestanding substrate-making can be performed using a chemical etching method, a laser irradiation method, a polish processing method, etc.

By making the substrate freestanding, a response to a process has an advantage of becoming easier in subsequent additional film-forming and device processing.

Moreover, also in the case of using the diamond as an electronic and magnetic device, the single crystal diamond freestanding structure substrate composed of only the single crystal diamond layer may be favorable since no influence from the intermediate layer or below is present.

### (Single Crystal Diamond Additional Forming Step: S16 in FIG. 6)

Furthermore, in the present invention, an additional single crystal diamond layer 41 is further formed on the single crystal diamond freestanding structure substrate 35 obtained up to the step S15 (Step S16), thereby producing the single crystal diamond freestanding structure substrate 40 (see FIG. 4). That is, the additional film forming can be performed on the single crystal diamond freestanding structure substrate 35 composed of only the single crystal diamond layer 31 shown in FIG. 3. Because the film is formed on a single material, breakage is absent and it is effective in reducing stress. This step is also advantageous for thickening a diamond film.

The additional single crystal diamond layer 41 formed in this step may be undoped, doped, or a combination thereof.

When a surface of the single crystal diamond freestanding structure substrate 35, being a to-be-underlayer, is polish processed before the additional forming of the additional single crystal diamond layer 41, a crystal being smooth with few defects can be obtained.

According to the inventive methods for producing an underlying substrate, a single crystal diamond laminate substrate, and a single crystal diamond freestanding structure substrate described above, the method can be provided in which the laminate substrate having the single crystal diamond layer with a large diameter, high crystallinity, few hillocks, few abnormal growth particles, few dislocation defects, etc., high purity, low stress, and high quality and suitable for an electronic and magnetic device is produced at low cost.

### EXAMPLE

Hereinafter, the present invention will be specifically described with reference to Examples and Comparative Example. However, the present invention is not limited to Examples described below.

### (Example 1)

A single crystal α-Al₂O₃ wafer having a diameter of 150 mm, a thickness of 1000 µm, and a crystal plane orientation {0001}, an off angle of 16° in <11-20> direction, and double-side polished was provided as an initial substrate 11 (see the initial substrate 11 in FIG. 1) (Step S11 in FIGs. 5 and 6).

Next, an Ir film was heteroepitaxially grown on a surface of the initial substrate 11 to form an intermediate layer 21 of an Ir film {111} (Step S12 in FIGs. 5 and 6).

An R.F. (13.56 MHz) magnetron sputtering method was used for forming the Ir film as the intermediate layer 21, in which an Ir target having a diameter of 8 inches (200 mm), a thickness of 5 mm, and a purity of 99.9% or more was used as a target. A substrate was heated to 850°C and then evacuated by a vacuum pump, and after confirming a base pressure of about 8.0×10⁻⁵ Pa or less, an Ar gas was introduced. After making a pressure of 14 Pa by adjusting an aperture of a valve connecting to an exhaust system, a film formation was performed for 30 minutes by inputting an R.F. 1500 W. A film thickness obtained was about 1 µm.

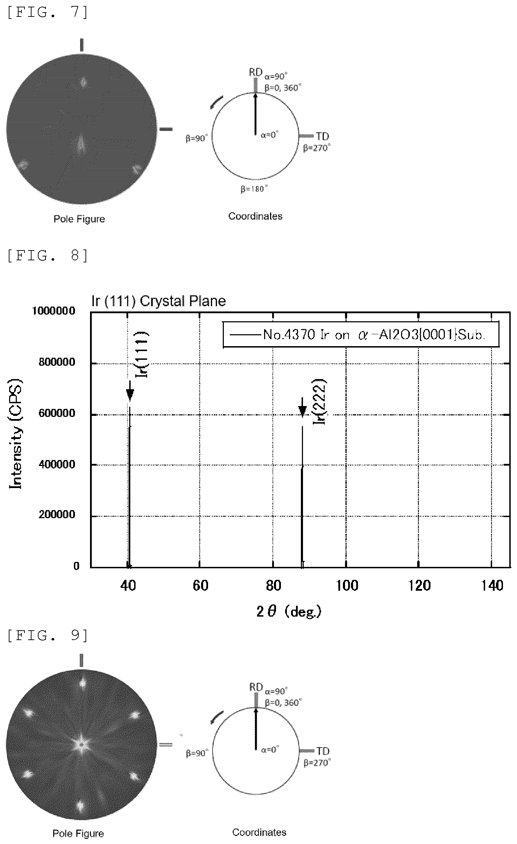

Crystallinity was measured from an outermost surface of the film by a pole method and an Out-of-plane method using an X-ray diffraction (XRD) apparatus (SmartLab manufactured by Rigaku Corporation). As a result, in the pole method, a (111) plane diffraction peak was detected while a (111) plane was oriented toward a substrate main surface normal direction, and a (111) plane diffraction peak was undetected while a (001) plane was oriented toward a substrate main surface normal direction. The result of the pole method is shown in FIG. 7. This was a spot arrangement of the (111) diffraction peak when no twin crystals were composed of {111}.

On the other hand, in the Out-of-plane method, only a diffracted intensity main peak at 2θ = 40.7° assigned to Ir (111) and a multiple reflection peak thereof were observed and it was confirmed that the intermediate layer was epitaxially grown single crystal Ir (111) crystal. The result of the Out-of-plane method is shown in FIG. 8. A rocking curve half width of an Ir (111) peak was 0.13°.

In the above manner, the inventive underlying substrate 20 was produced (see FIG. 1).

Next, a pretreatment (bias treatment) for forming a diamond nucleus was performed on the underlying substrate 20 (Step S13 in FIG. 6). Here, the underlying substrate 20, in which the intermediate layer 21 was formed, was placed on a planar electrode, and after confirming that a base pressure was about 1.3×10⁻⁴ Pa or less, hydrogen-diluted methane (CH_{4/}(CH₄+H₂) = 5.0 vol.%) was introduced into a treatment chamber at a flow rate of 500 sccm. After making the pressure 1.3×10⁴ Pa by adjusting the aperture of the valve connected to the exhaust system, a negative voltage was applied to the electrode at the substrate side to expose the substrate to plasma for 90 seconds, and thereby the surface of the intermediate layer 21 (that is, the surface of a single crystal Ir {111} film) was subjected to bias treatment.

Subsequently, a single crystal diamond layer 31 (undoped diamond film) was heteroepitaxially grown by a microwave CVD method (Step S14 in FIG. 6). Here, the bias-treated underlying substrate 20 was placed in a chamber of a microwave CVD apparatus, and after being evacuated by a vacuum pump until a base pressure was about 1.3×10⁻⁴ Pa or less, and then hydrogen-diluted methane (CH_{4/}(CH₄+H₂) = 4.0 vol.%), being a raw material gas, was introduced into the treatment chamber at a flow rate of 1000 sccm. After making the pressure 1.5×10⁴ Pa by adjusting the aperture of the valve connected to the exhaust system, the film formation was performed for 150 hours with direct current applied. A substrate temperature during the film formation, which was measured with a pyrometer, was 980°C.

The single crystal diamond layer 31 obtained had no delamination on an entire surface, which had a diameter of 150 mm, and was a completely continuous film. A schematic cross-sectional view of the single crystal diamond laminate substrate 30 produced in this way is shown in FIG. 2.

Next, an α-Al₂O₃ wafer, being the initial substrate 11, was etched with hot phosphoric acid. Moreover, the Ir film, being the intermediate layer 21, was removed by dry etching. Consequently, a single crystal diamond {111} freestanding substrate 35 was obtained (Step S15 in FIG. 6).

Finally, the single crystal diamond layer (additional single crystal diamond layer 41) was heteroepitaxially grown by the microwave CVD method again (Step S16 in FIG. 6). The formation of this additional single crystal diamond layer 41 was performed under the same condition as the formation of the undoped diamond film described above.

The single crystal diamond layer obtained also had no delamination on an entire surface, which had a diameter of 150 mm, and was a completely continuous film. A schematic cross-sectional view of a single crystal diamond freestanding structure substrate 40 composed of the single crystal diamond layer 31 and the additional single crystal diamond layer 41 is shown in FIG. 4.

A 2 mm square was cut out from this single crystal diamond freestanding structure substrate 40 to make a sample for evaluation, and then an evaluation was performed for film thickness and crystallinity.

Regarding the film thickness, when the sample cross-section was observed by a scanning secondary electron microscope (SEM), a total thickness of the diamond layers was about 400 µm.

The crystallinity was measured from an outermost surface of the film using the X-ray diffraction (XRD) apparatus (SmartLab manufactured by Rigaku Corporation). As a result, only a diffracted intensity peak at 2θ = 43.9° assigned to a diamond (111) was observed, and thus, the diamond layer was confirmed to be an epitaxially grown single crystal diamond {111} crystal. No twin crystal components were found either.

When the single crystal diamond {111} laminate substrate and the freestanding substrate are applied to an electronic and magnetic device, a high-performance device can be obtained. For example, a high-performance power device can be obtained.

Moreover, since the device can be obtained on a large-diameter substrate, the production cost can be kept low.

### (Example 2)

A single crystal α-Al₂O₃ wafer having a diameter of 150 mm, a thickness of 1000 µm, and a crystal plane orientation {0001}, an off angle of 8° in <11-20> direction, and double-side polished was provided as an initial substrate 11 (see the initial substrate 11 in FIG. 1) (Step S11 in FIGs. 5 and 6).

Next, an Ir film was heteroepitaxially grown on a surface of the initial substrate 11 to form an intermediate layer 21 of an Ir film {111} (Step S12 in FIGs. 5 and 6).

An R.F. (13.56MHz) magnetron sputtering method was used for forming the Ir film as the intermediate layer 21, in which an Ir target having a diameter of 8 inches (200 mm), a thickness of 5 mm, and a purity of 99.9% or more was used as a target. A substrate was heated to 850°C and then evacuated by a vacuum pump, and after confirming a base pressure of about 8.0×10⁻⁵ Pa or less, an Ar gas was introduced. After making a pressure of 14 Pa by adjusting an aperture of a valve connecting to an exhaust system, a film formation was performed for 30 minutes by inputting an R.F. 1500 W. A film thickness obtained was about 1 µm.

Crystallinity was measured from an outermost surface of the film by a pole method and an Out-of-plane method using an X-ray diffraction (XRD) apparatus (SmartLab manufactured by Rigaku Corporation). As a result, twin crystal components composing Ir {111} were also absent, only a diffracted intensity main peak at 2θ = 40.7° assigned to Ir (111) and a multiple reflection peak thereof were observed and it was confirmed that the intermediate layer was epitaxially grown single crystal Ir (111) crystal. A rocking curve half width of the Ir (111) peak was 0.12°.

In the above manner, the inventive underlying substrate 20 was produced (see FIG. 1).

Next, a pretreatment (bias treatment) for forming a diamond nucleus was performed on the underlying substrate 20 (Step S13 in FIG. 6). Here, the underlying substrate 20, in which the intermediate layer 21 was formed, was placed on a planar electrode, and after confirming that a base pressure was about 1.3×10⁻⁴ Pa or less, hydrogen-diluted methane (CH_{4/}(CH₄+H₂) = 5.0 vol. %) was introduced into a treatment chamber at a flow rate of 500 sccm. After making the pressure 1.3×10⁴ Pa by adjusting the aperture of the valve connected to the exhaust system, a negative voltage was applied to the electrode at the substrate side to expose the substrate to plasma for 90 seconds, and thereby the surface of the intermediate layer 21 (that is, the surface of a single crystal Ir {111} film) was subjected to bias treatment.

Subsequently, a single crystal diamond layer 31 (undoped diamond film) was heteroepitaxially grown by a microwave CVD method (Step S14 in FIG. 6). Here, the bias-treated underlying substrate 20 was placed in a chamber of a microwave CVD apparatus, and after being evacuated by a vacuum pump until a base pressure was about 1.3×10⁻⁴ Pa or less, and then hydrogen-diluted methane (CH_{4/}(CH₄+H₂) = 4.0 vol.%), being a raw material gas, was introduced into the treatment chamber at a flow rate of 1000 sccm. After making the pressure 1.5×10⁴ Pa by adjusting the aperture of the valve connected to the exhaust system, the film formation was performed for 80 hours with direct current applied. A substrate temperature during the film formation, which was measured with a pyrometer, was 980°C.

The single crystal diamond layer 31 obtained also had no delamination on an entire surface, which had a diameter of 150 mm, and was a completely continuous film. A schematic cross-sectional view of the single crystal diamond laminate substrate 30 produced in this way is shown in FIG. 2.

A 2 mm square was cut out from this single crystal diamond laminate substrate 30 to make a sample for evaluation, and then an evaluation was performed for film thickness and crystallinity.

Regarding the film thickness, when the sample cross-section was observed by a scanning secondary electron microscope (SEM), a total thickness of the diamond layers was about 100 µm. Compared with Example 1, the film was thin but turned out to be a continuous film having a smooth surface. A dislocation defect density was also successfully reduced.

The crystallinity was measured from an outermost surface of the film using the X-ray diffraction (XRD) apparatus (SmartLab manufactured by Rigaku Corporation). As a result, only a diffracted intensity peak at 2θ = 43.9° assigned to a diamond (111) was observed, and thus, the diamond layer was confirmed to be an epitaxially grown single crystal diamond {111} crystal. Twin crystals were also absent.

When the single crystal diamond {111} laminate substrate is applied to an electronic and magnetic device, a high-performance device can be obtained. For example, a high-performance power device can be obtained.

Moreover, since the device can be obtained on a large-diameter substrate, the production cost can be kept low.

### (Example 3)

A single crystal α-Al₂O₃ wafer having a diameter of 150 mm, a thickness of 1000 µm, and a crystal plane orientation {0001}, an off angle of 24° in <11-20> direction, and double-side polished was provided as an initial substrate 11 (see the initial substrate 11 in FIG. 1) (Step S11 in FIGs. 5 and 6).

Next, an Ir film was heteroepitaxially grown on a surface of the initial substrate 11 to form an intermediate layer 21 of an Ir film {111} (Step S12 in FIGs. 5 and 6).

An R.F. (13.56MHz) magnetron sputtering method was used for forming the Ir film as the intermediate layer 21, in which an Ir target having a diameter of 8 inches (200 mm), a thickness of 5 mm, and a purity of 99.9% or more was used as a target. A substrate was heated to 850°C and then evacuated by a vacuum pump, and after confirming a base pressure of about 8.0×10⁻⁵ Pa or less, an Ar gas was introduced. After making a pressure of 14 Pa by adjusting an aperture of a valve connecting to an exhaust system, a film formation was performed for 30 minutes by inputting an R.F. 1500 W. A film thickness obtained was about 1 µm.

Crystallinity was measured from an outermost surface of the film by a pole method and an Out-of-plane method using an X-ray diffraction (XRD) apparatus (SmartLab manufactured by Rigaku Corporation). As a result, twin crystal components composing Ir {111} were also absent, only a diffracted intensity main peak at 2θ = 88.1° assigned to Ir (222) and a multiple reflection peak thereof were observed and it was confirmed that the intermediate layer was epitaxially grown single crystal Ir (111) crystal. A rocking curve half width of the Ir (222) peak was 0.12°.

In the above manner, the inventive underlying substrate 20 was produced (see FIG. 1).

Next, a pretreatment (bias treatment) for forming a diamond nucleus was performed on the underlying substrate 20 (Step S13 in FIG. 6). Here, the underlying substrate 20, in which the intermediate layer 21 was formed, was placed on a planar electrode, and after confirming that a base pressure was about 1.3×10⁻⁴ Pa or less, hydrogen-diluted methane (CH_{4/}(CH₄+H₂) = 5.0 vol.%) was introduced into a treatment chamber at a flow rate of 500 sccm. After making the pressure 1.3×10⁴ Pa by adjusting the aperture of the valve connected to the exhaust system, a negative voltage was applied to the electrode at the substrate side to expose the substrate to plasma for 90 seconds, and thereby the surface of the intermediate layer 21 (that is, the surface of a single crystal Ir {111} film) was subjected to bias treatment.

Subsequently, a single crystal diamond layer 31 (undoped diamond film) was heteroepitaxially grown by a microwave CVD method (Step S14 in FIG. 6). Here, the bias-treated underlying substrate 20 was placed in a chamber of a microwave CVD apparatus, and after being evacuated by a vacuum pump until a base pressure was about 1.3×10⁻⁴ Pa or less, and then hydrogen-diluted methane (CH_{4/}(CH₄+H₂) = 4.0 vol.%), being a raw material gas, was introduced into the treatment chamber at a flow rate of 1000 sccm. After making the pressure 1.5×10⁴ Pa by adjusting the aperture of the valve connected to the exhaust system, the film formation was performed for 80 hours with direct current applied. A substrate temperature during the film formation, which was measured with a pyrometer, was 980°C.

The single crystal diamond layer 31 obtained also had no delamination on an entire surface, which had a diameter of 150 mm, and was a completely continuous film. A schematic cross-sectional view of the single crystal diamond laminate substrate 30 produced in this way is shown in FIG. 2.

A 2 mm square was cut out from this single crystal diamond laminate substrate 30 to make a sample for evaluation, and then an evaluation was performed for film thickness and crystallinity.

Regarding the film thickness, when the sample cross-section was observed by a scanning secondary electron microscope (SEM), a total thickness of the diamond layers was about 100 µm. Compared with Example 1, the film was thin but turned out to be a continuous film having a smooth surface. A dislocation defect density was also successfully reduced.

The crystallinity was measured from an outermost surface of the film using the X-ray diffraction (XRD) apparatus (SmartLab manufactured by Rigaku Corporation). As a result, only a diffracted intensity peak at 2θ = 43.9° assigned to a diamond (111) was observed, and thus, the diamond layer was confirmed to be an epitaxially grown single crystal diamond {111} crystal. Twin crystals were also absent.

When the single crystal diamond {111} laminate substrate is applied to an electronic and magnetic device, a high-performance device can be obtained. For example, a high-performance power device can be obtained.

Moreover, since the device can be obtained on a large-diameter substrate, the production cost can be kept low.

In Comparative Example described below, while the off angle of the initial substrate 11, the crystallinity of the intermediate layer 21, etc., in FIGs 1 and 2 used in the description of Examples 1 to 3 are different from Examples, the cross-sectional structure is generally the same with FIGs. 1 and 2. Moreover, in FIGs 5 and 6 used in the description of Examples 1 to 3, the steps are the same except for the difference in the off angle of the initial substrate provided.

### (Comparative Example)

A single crystal α-Al₂O₃ wafer having a diameter of 150 mm, a thickness of 1000 µm, and a crystal plane orientation {0001}, and double-side polished (no off angle) was provided as an initial substrate 11 (corresponding to an initial substrate 11, which is in FIG. 1 of Examples, with no off angle) (corresponding to Step S11 in FIGs. 5 and 6 in Examples).

Next, an Ir film was heteroepitaxially grown on a surface of the initial substrate 11 to form an intermediate layer 21 of an Ir film {111} (corresponding to Step S12 in FIGs. 5 and 6 in Examples).

An R.F. (13.56MHz) magnetron sputtering method was used for forming the Ir film as the intermediate layer 21, in which an Ir target having a diameter of 8 inches (200 mm), a thickness of 5 mm, and a purity of 99.9% or more was used as a target. A substrate was heated to 850°C and then evacuated by a vacuum pump, and after confirming a base pressure of about 8.0×10⁻⁵ Pa or less, an Ar gas was introduced. After making a pressure of 14 Pa by adjusting an aperture of a valve connecting to an exhaust system, a film formation was performed for 30 minutes by inputting an R.F. 1500 W. A film thickness obtained was about 1 µm.

Crystallinity was measured from an outermost surface of the film by a pole method and an Out-of-plane method using an X-ray diffraction (XRD) apparatus (SmartLab manufactured by Rigaku Corporation). As a result, in the pole method, a {111} plane diffraction peak was detected while a {111} plane was oriented toward a substrate main surface normal direction, and a {111} plane diffraction peak was undetected while a {001} plane was oriented toward a substrate main surface normal direction. The result of the pole method is shown in FIG. 9. This was a spot arrangement of the {111} diffraction peak when {111} was composed of twin crystals.

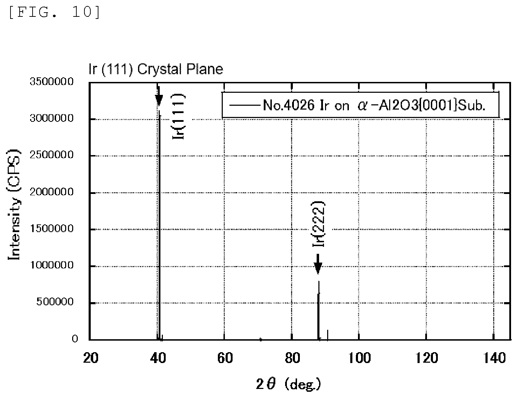

Moreover, in the Out-of-plane method, only a diffracted intensity main peak at 2θ = 40.7° assigned to Ir (111) and a multiple reflection peak thereof were observed and it was confirmed that the intermediate layer was epitaxially grown single crystal Ir {111} crystal. The result of the Out-of-plane method is shown in FIG. 10. A rocking curve half width of the Ir {111} peak was 0.16°.

In the above manner, an underlying substrate 20 in Comparative Example was produced (corresponding to an initial substrate 11, which is in FIG. 1 of Examples, with the off angle changed).

Next, a pretreatment (bias treatment) for forming a diamond nucleus was performed on the underlying substrate 20 (corresponding to Step S13 in FIG. 6 in Examples). Here, the underlying substrate 20, in which the intermediate layer 21 was formed, was placed on a planar electrode, and after confirming that a base pressure was about 1.3×10⁻⁴ Pa or less, hydrogen-diluted methane (CH_{4/}(CH₄+H₂) = 5.0 vol.%) was introduced into a treatment chamber at a flow rate of 500 sccm. After making the pressure 1.3×10⁴ Pa by adjusting the aperture of the valve connected to the exhaust system, a negative voltage was applied to the electrode at the substrate side to expose the substrate to plasma for 90 seconds, and thereby the surface of the intermediate layer 21 (that is, the surface of a single crystal Ir {111} film) was subjected to bias treatment.

Subsequently, a single crystal diamond layer 31 (undoped diamond film) was heteroepitaxially grown by a microwave CVD method (corresponding to Step S14 in FIG. 6 in Examples). Here, the bias-treated underlying substrate 20 was placed in a chamber of a microwave CVD apparatus, and after being evacuated by a vacuum pump until a base pressure was about 1.3×10⁻⁴ Pa or less, and then hydrogen-diluted methane (CH_{4/}(CH₄+H₂) = 4.0 vol.%), being a raw material gas, was introduced into the treatment chamber at a flow rate of 1000 sccm. After making the pressure 1.5×10⁴ Pa by adjusting the aperture of the valve connected to the exhaust system, the film formation was performed for 150 hours with direct current applied. A substrate temperature during the film formation, which was measured with a pyrometer, was 980°C.

The single crystal diamond layer 31 obtained had no delamination on an entire surface, which had a diameter of 150 mm, and was a completely continuous film. A schematic cross-sectional view of the single crystal diamond laminate substrate 30 produced in this way had the same structure as in FIG. 2 in Examples.

Next, an α-Al₂O₃ wafer, being the initial substrate 11, was etched with hot phosphoric acid. Moreover, the Ir film, being the intermediate layer 21, was removed by dry etching. Consequently, a single crystal diamond {111} freestanding substrate 35 was obtained (corresponding to Step S15 in FIG. 6 in Examples).

Finally, the single crystal diamond layer (additional single crystal diamond layer 41) was heteroepitaxially grown by the microwave CVD method again (corresponding to Step S16 in FIG. 6 in Examples). The formation of this additional single crystal diamond layer 41 was performed under the same condition as the formation of the undoped diamond film described above.

The single crystal diamond layer obtained also had no delamination on an entire surface, which had a diameter of 150 mm, and was a completely continuous film. A schematic cross-sectional view of a single crystal diamond freestanding structure substrate 40 composed of the single crystal diamond layer 31 and the additional single crystal diamond layer 41 had the same structure as in FIG. 4 in Examples.

A 2 mm square was cut out from this single crystal diamond freestanding structure substrate 40 to make a sample for evaluation, and then an evaluation was performed for film thickness and crystallinity.

Regarding the film thickness, when the sample cross-section was observed by a scanning secondary electron microscope (SEM), a total thickness of the diamond layers was about 400 µm.

The crystallinity was measured from an outermost surface of the film using the X-ray diffraction (XRD) apparatus (SmartLab manufactured by Rigaku Corporation). As a result, a diffracted intensity peak at 2θ = 43.9° assigned to a diamond (111) was observed, and thus, the diamond layer was confirmed to be an epitaxially grown single crystal diamond {111} crystal. Twin crystal components were present.

As described above, it was found that the twin crystal components were present in the single crystal diamond crystal in Comparative Example and this crystal is the single crystal diamond layer of low quality with more abnormal growths, more dislocation defects, etc., when compared with Examples. When the single crystal diamond {111} laminate substrate and the freestanding substrate according to Comparative Example are applied to an electronic and magnetic device, it is considered difficult to obtain a high-performance device when compared with Examples.

The present description includes the following embodiments.
[1]: An underlying substrate for a single crystal diamond laminate substrate, the underlying substrate comprising:
   an initial substrate being any of a single crystal Si {111} substrate, a single crystal Si {001} substrate, a single crystal α-Al₂O₃ {0001} substrate, a single crystal α-Al₂O₃ {11-20} substrate, a single crystal Fe {111} substrate, a single crystal Fe (001} substrate, a single crystal Ni {111} substrate, a single crystal Ni {001} substrate, a single crystal Cu {111} substrate, and a single crystal Cu {001} substrate; and
   an intermediate layer comprising a single layer or a laminate film on the initial substrate containing at least any one of a single crystal Ir film, a single crystal MgO film, a single crystal yttria-stabilized zirconia film, a single crystal SrTiO₃ film, and a single crystal Ru film, wherein
   an outermost surface on the initial substrate has an off angle in a crystal axis <-1-12> direction relative to a cubic crystal plane orientation {111}, or has an off angle in a crystal axis <10-10> or <11-20> direction relative to a hexagonal crystal plane orientation {0001}, or has an off angle in a crystal axis <110> direction relative to a cubic crystal plane orientation {001}, or has an off angle in a crystal axis <10-10> or <0001> direction relative to a hexagonal crystal plane orientation {11-20}.
[2]: The underlying substrate according to the above [1], wherein
   the off angle of the outermost surface on the initial substrate is in a range of +8.0° to +24.0° or - 8.0° to -24.0°.
[3]: The underlying substrate according to the above [1] or [2], wherein
   the off angle of the outermost surface on the initial substrate is in a range of greater than +15.0° to +24.0° or less, or greater than -15.0° to -24.0° or less.
[4]: The underlying substrate according to the above [1], [2] or [3], wherein
   an outermost surface on the intermediate layer has an off angle in a crystal axis <-1-12> direction relative to a cubic crystal plane orientation {111}, or has an off angle in a crystal axis <10-10> or <11-20> direction relative to a hexagonal crystal plane orientation {0001}, or has an off angle in a crystal axis <110> direction relative to a cubic crystal plane orientation {001}, or has an off angle in a crystal axis <10-10> or <0001> direction relative to a hexagonal crystal plane orientation {11-20}.
[5]: The underlying substrate according to the above [4], wherein
   the off angle of the outermost surface on the intermediate layer is in a range of +8.0° to +24.0° or - 8.0° to -24.0°.
[6]: The underlying substrate according to the above [4] or [5], wherein
   the off angle of the outermost surface on the intermediate layer is in a range of greater than +15.0° to +24.0° or less, or greater than -15.0° to -24.0° or less.
[7]: A single crystal diamond laminate substrate comprising a single crystal diamond layer on the intermediate layer of the underlying substrate of the above [1], [2], [3], [4], [5] or [6].
[8]: The single crystal diamond laminate substrate according to the above [7], wherein
   the single crystal diamond layer is a {111} crystal or a {001} crystal.
[9]: A method for producing an underlying substrate for a single crystal diamond laminate substrate, the method comprising the steps of:
   providing an initial substrate being any of a single crystal Si {111} substrate, a single crystal Si {001} substrate, a single crystal α-Al₂O₃ {0001} substrate, a single crystal α-Al₂O₃ {11-20} substrate, a single crystal Fe {111} substrate, a single crystal Fe {001} substrate, a single crystal Ni {111} substrate, a single crystal Ni {001} substrate, a single crystal Cu {111} substrate, and a single crystal Cu {001} substrate; and
   forming an intermediate layer comprising a single layer or a laminate film on the initial substrate containing at least any one of a single crystal Ir film, a single crystal MgO film, a single crystal yttria-stabilized zirconia film, a single crystal SrTiO₃ film, and a single crystal Ru film, wherein
   the initial substrate is used with any of the outermost surfaces on the initial substrates which have an off angle in a crystal axis <-1-12> direction relative to a cubic crystal plane orientation {111}, or have an off angle in a crystal axis <10-10> or <11-20> direction relative to a hexagonal crystal plane orientation {0001}, or have an off angle in a crystal axis <110> direction relative to a cubic crystal plane orientation {001}, or have an off angle in a crystal axis <10-10> or <0001> direction relative to a hexagonal crystal plane orientation {11-20}.
[10]: The method for producing an underlying substrate according to the above [9], wherein
   the off angle of the outermost surface on the initial substrate is in a range of +8.0° to +24.0° or - 8.0° to -24.0°.
[11]: The method for producing an underlying substrate according to the above [9] or [10], wherein
   the off angle of the outermost surface on the initial substrate is in a range of greater than +15.0° to +24.0° or less, or greater than -15.0° to -24.0° or less.
[12]: The method for producing an underlying substrate according to the above [9], [10] or [11], wherein
   an outermost surface on the intermediate layer has an off angle in a crystal axis <-1-12> direction relative to a cubic crystal plane orientation {111}, or has an off angle in a crystal axis <10-10> or <11-20> direction relative to a hexagonal crystal plane orientation {0001}, or has an off angle in a crystal axis <110> direction relative to a cubic crystal plane orientation {001}, or has an off angle in a crystal axis <10-10> or <0001> direction relative to a hexagonal crystal plane orientation {11-20}.
[13]: The method for producing an underlying substrate according to the above [12], wherein
   the intermediate layer is formed with the off angle of the outermost surface on the intermediate layer in a range of +8.0° to +24.0° or -8.0° to -24.0°.
[14]: The method for producing an underlying substrate according to the above [12] or [13], wherein
   the intermediate layer is formed with the off angle of the outermost surface on the intermediate layer in a range of greater than +15.0° to +24.0° or less, or greater than -15.0° to -24.0° or less.
[15]: A method for producing a single crystal diamond laminate substrate, the method comprising the steps of:
   providing an underlying substrate produced by the method for producing an underlying substrate of the above [9], [10], [11], [12], [13] or [14];
   performing a bias treatment on a surface of the intermediate layer of the underlying substrate to form a diamond nucleus; and
   growing the diamond nucleus formed on the intermediate layer to perform epitaxial growth, thereby forming a single crystal diamond layer.
[16]: The method for producing a single crystal diamond laminate substrate according to the above [15], wherein
   the single crystal diamond layer is a {111} crystal or a {001} crystal.
[17]: A method for producing a single crystal diamond freestanding structure substrate, the method comprising taking out only the single crystal diamond layer from a single crystal diamond laminate substrate produced by the method for producing a single crystal diamond laminate substrate of the above [15] or [16] to produce a single crystal diamond freestanding structure substrate.
[18]: A method for producing a single crystal diamond freestanding structure substrate, the method comprising further forming an additional single crystal diamond layer on a single crystal diamond freestanding structure substrate obtained by the method for producing a single crystal diamond freestanding structure substrate of the above [17].

It should be noted that the present invention is not limited to the above-described embodiments. The embodiments are just examples, and any examples that have substantially the same feature and demonstrate the same functions and effects as those in the technical concept disclosed in claims of the present invention are included in the technical scope of the present invention.

## Claims

1. An underlying substrate for a single crystal diamond laminate substrate, the underlying substrate comprising:
an initial substrate being any of a single crystal Si {111} substrate, a single crystal Si {001} substrate, a single crystal α-Al₂O₃ {0001} substrate, a single crystal α-Al₂O₃ {11-20} substrate, a single crystal Fe {111} substrate, a single crystal Fe {001} substrate, a single crystal Ni {111} substrate, a single crystal Ni {001} substrate, a single crystal Cu {111} substrate, and a single crystal Cu {001} substrate; and
an intermediate layer comprising a single layer or a laminate film on the initial substrate containing at least any one of a single crystal Ir film, a single crystal MgO film, a single crystal yttria-stabilized zirconia film, a single crystal SrTiO₃ film, and a single crystal Ru film, wherein
an outermost surface on the initial substrate has an off angle in a crystal axis <-1-12> direction relative to a cubic crystal plane orientation {111}, or has an off angle in a crystal axis <10-10> or <11-20> direction relative to a hexagonal crystal plane orientation {0001}, or has an off angle in a crystal axis <110> direction relative to a cubic crystal plane orientation {001}, or has an off angle in a crystal axis <10-10> or <0001> direction relative to a hexagonal crystal plane orientation {11-20}.

2. The underlying substrate according to claim 1, wherein
the off angle of the outermost surface on the initial substrate is in a range of +8.0° to +24.0° or - 8.0° to -24.0°.

3. The underlying substrate according to claim 1, wherein
the off angle of the outermost surface on the initial substrate is in a range of greater than +15.0° to +24.0° or less, or greater than -15.0° to -24.0° or less.

4. The underlying substrate according to claim 1, wherein
an outermost surface on the intermediate layer has an off angle in a crystal axis <-1-12> direction relative to a cubic crystal plane orientation {111}, or has an off angle in a crystal axis <10-10> or <11-20> direction relative to a hexagonal crystal plane orientation {0001}, or has an off angle in a crystal axis <110> direction relative to a cubic crystal plane orientation {001}, or has an off angle in a crystal axis <10-10> or <0001> direction relative to a hexagonal crystal plane orientation {11-20}.

5. The underlying substrate according to claim 4, wherein
the off angle of the outermost surface on the intermediate layer is in a range of +8.0° to +24.0° or - 8.0° to -24.0°.

6. The underlying substrate according to claim 4, wherein
the off angle of the outermost surface on the intermediate layer is in a range of greater than +15.0° to +24.0° or less, or greater than -15.0° to -24.0° or less.

7. A single crystal diamond laminate substrate comprising a single crystal diamond layer on the intermediate layer of the underlying substrate according to any one of claims 1 to 6.

8. The single crystal diamond laminate substrate according to claim 7, wherein
the single crystal diamond layer is a {111} crystal or a {001} crystal.

9. A method for producing an underlying substrate for a single crystal diamond laminate substrate, the method comprising the steps of:
providing an initial substrate being any of a single crystal Si {111} substrate, a single crystal Si {001} substrate, a single crystal α-Al₂O₃ {0001} substrate, a single crystal α-Al₂O₃ {11-20} substrate, a single crystal Fe {111} substrate, a single crystal Fe {001} substrate, a single crystal Ni {111} substrate, a single crystal Ni {001} substrate, a single crystal Cu {111} substrate, and a single crystal Cu {001} substrate; and
forming an intermediate layer comprising a single layer or a laminate film on the initial substrate containing at least any one of a single crystal Ir film, a single crystal MgO film, a single crystal yttria-stabilized zirconia film, a single crystal SrTiO₃ film, and a single crystal Ru film, wherein
the initial substrate is used with any of the outermost surfaces on the initial substrates which have an off angle in a crystal axis <-1-12> direction relative to a cubic crystal plane orientation {111}, or have an off angle in a crystal axis <10-10> or <11-20> direction relative to a hexagonal crystal plane orientation {0001}, or have an off angle in a crystal axis <110> direction relative to a cubic crystal plane orientation {001}, or have an off angle in a crystal axis <10-10> or <0001> direction relative to a hexagonal crystal plane orientation {11-20}.

10. The method for producing an underlying substrate according to claim 9, wherein
the off angle of the outermost surface on the initial substrate is in a range of +8.0° to +24.0° or - 8.0° to -24.0°.

11. The method for producing an underlying substrate according to claim 9, wherein
the off angle of the outermost surface on the initial substrate is in a range of greater than +15.0° to +24.0° or less, or greater than -15.0° to -24.0° or less.

12. The method for producing an underlying substrate according to claim 9, wherein
an outermost surface on the intermediate layer has an off angle in a crystal axis <-1-12> direction relative to a cubic crystal plane orientation {111}, or has an off angle in a crystal axis <10-10> or <11-20> direction relative to a hexagonal crystal plane orientation {0001}, or has an off angle in a crystal axis <110> direction relative to a cubic crystal plane orientation {001}, or has an off angle in a crystal axis <10-10> or <0001> direction relative to a hexagonal crystal plane orientation {11-20}.

13. The method for producing an underlying substrate according to claim 12, wherein
the intermediate layer is formed with the off angle of the outermost surface on the intermediate layer in a range of +8.0° to +24.0° or -8.0° to -24.0°.

14. The method for producing an underlying substrate according to claim 12, wherein
the intermediate layer is formed with the off angle of the outermost surface on the intermediate layer in a range of greater than +15.0° to +24.0° or less, or greater than -15.0° to -24.0° or less.

15. A method for producing a single crystal diamond laminate substrate, the method comprising the steps of:
providing an underlying substrate produced by the method for producing an underlying substrate according to any one of claims 9 to 14;
performing a bias treatment on a surface of the intermediate layer of the underlying substrate to form a diamond nucleus; and
growing the diamond nucleus formed on the intermediate layer to perform epitaxial growth, thereby forming a single crystal diamond layer.

16. The method for producing a single crystal diamond laminate substrate according to claim 15, wherein
the single crystal diamond layer is a {111} crystal or a {001} crystal.

17. A method for producing a single crystal diamond freestanding structure substrate, the method comprising taking out only the single crystal diamond layer from a single crystal diamond laminate substrate produced by the method for producing a single crystal diamond laminate substrate according to claim 15 to produce a single crystal diamond freestanding structure substrate.

18. A method for producing a single crystal diamond freestanding structure substrate, the method comprising further forming an additional single crystal diamond layer on a single crystal diamond freestanding structure substrate obtained by the method for producing a single crystal diamond freestanding structure substrate according to claim 17.
